# EUROPEAN PATENT APPLICATION

(11) **EP 1 736 308 A1**
(43) Date of publication of application: **27.12.2006**
(21) Application number: 05730341.4
(22) Date of filing: 12.04.2005
(51) Int. Cl.: B32B 9/00, B32B 27/30, C08F 220/18

(54) **TRANSPARENT GAS BARRIER MULTILAYER FILM**

(30) Priority: 15.04.2004 JP 2004119976; 06.07.2004 JP 2004198971
(71) Applicant: TEIJIN LIMITED, Osaka-shi Osaka 541-0054 (JP)
(72) Inventor: HARA, Hiroshi c/o Teijin Limited,Tokyo Res. Ctr., Hino-shi, Tokyo 1910065 (JP); ITO, Haruhiko c/o Teijin Limited,Tokyo Res. Ctr., Hino-shi, Tokyo 1910065 (JP); SHIROISHI, Isao c/o Teijin Ltd.,Tokyo Res. Ctr, Hino-shi, Tokyo 1910065 (JP)
(74) Representative: Hallybone, Huw George
(86) International application number: PCT/JP2005/007369
(87) International publication number: WO 2005/100014

(57) **Abstract**

The transparent gas-barrier layered film of the present invention has a resin layer containing an acrylate resin having a lactone ring and a layer comprising an inorganic metal compound at least on one side of a macromolecular film. The transparent gas-barrier layered film has a high transparency and shows an excellent gas-barrier property against vapor. Therefore, it is able to be advantageously used as a substrate of, for example, electronic paper, liquid crystal display device, touch panel, organic light emitting diode element, filmy solar battery and electronic tag.

## Description

### Technical Field

The present invention relates to a transparent gas-barrier layered film and, more particularly, it relates to a transparent gas-barrier layered film having a high vapor-barrier property and being appropriate as a substrate for liquid crystal display element, touch panel, organic light emitting diode element and electronic paper.

### Background Art

Trends for small size and low energy consumption of various devices where downsizing is a keyword in recent years have a tendency of giving characteristics to light weight by such a means that substrates used for various kinds of display elements or thin-membrane solar batteries are changed from glass to macromolecular film. Since a macromolecular film is a material having a light weight and also much flexibility, it is able to suppress the destruction of various devices such as cracking. As such, movements of application of the macromolecular film to the field where glass had been used as a substrate are now more and more brisk.

Especially in the field of organic light emitting diode elements, life of luminescent layer and positive hole transportation layer is unilaterally decided by moisture contained in the element. Therefore, even when a macromolecular film is used as a substrate, there is a severe demand for its gas-barrier property. In the case of liquid crystal display elements, there is a demand that permeation of moisture and oxygen into liquid crystal layers are made as little as possible for guaranteeing the operation for a long period. Accordingly, it has been also investigated even in liquid crystal display elements to use a highly gas-barrier macromolecular film as a substrate. Further, in the field for novel display materials called electronic paper which has been briskly developed in recent years, there has been a demand for appearance of substrates using a macromolecular film having an excellent gas-barrier property for maintaining the high property as electronic devices.

In view of the above, there have been attempts for achieving a barrier function by producing a thin membrane comprising an inorganic compound, particularly an inorganic oxide, on a macromolecular film. For example, in JP-A-06-136161, there is disclosed an invention where a barrier function is enhanced by way of characterization of an inorganic oxide and, in JP-A-05-092507, there is disclosed an invention where a barrier property is endowed to a macromolecular film itself.

However, when the use of a macromolecular film as a substrate for display elements is taken into consideration, thin film produced from inorganic compounds is limited to materials which are able to maintain the transparency such as oxide, nitride and oxynitride. When a material which is able to maintain its transparency as such is formed on a macromolecular film, a sputtering method is often used because of the demand for uniform quality of the membrane.

However, it has been clarified that the thin membrane of inorganic compounds produced by a sputtering method forms pinholes and is unable to afford a high barrier property. It has been also said that uniformity in its thickness is insufficient. Accordingly, it has been attempted by an RF magnetron sputtering method to suppress the generation of pinholes by means of a full investigation of sputtering conditions or of a big change in plasma parameters.

### Disclosure of the Invention

A main object of the present invention is to provide a novel layered film having an excellent barrier property to vapor.

Another object of the present invention is to provide a layered film having a good transparency and also a high barrier property to vapor using a macromolecular film.

Other objects and advantages of the present invention will be apparent from the following descriptions.

In accordance with the present invention, objects arid advantages of the present invention are able to be achieved by a transparent gas-barrier layered film having a layer comprising an inorganic metal compound and a resin layer containing an acrylate resin having a lactone ring at least on one side of the macromolecular film.

The present inventors have carried out intensive investigations for a mechanism of expression of barrier property. As a result, they have found that, in the production of a layer of inorganic metal compound by a means called a sputtering method, the resulting barrier property greatly varies if film surface to which the inorganic metal compound is adhered is different even when a layer of the same inorganic metal compound is processed under the same condition. Thus, it has been found that, even in the layer of the same inorganic metal compound produced under the same condition, the resulting barrier property is greatly different depending upon the material of surface layer of the film to which the inorganic metal compound particles are adhered and upon the state thereof.

As a result of further investigation, the present inventors have quite unexpectedly found that, when a thin membrane layer comprising an inorganic metal compound is formed on a resin layer containing an acrylate resin having a lactone ring, a high barrier property against vapor is achieved whereupon the present invention has been achieved.

### Preferred Embodiments of the Present Invention

In the transparent gas-barrier layered film of the present invention, at least one of the surfaces of the macromolecular film has a resin layer containing an acrylate resin having a lactone ring and a layer (thin membrane) comprising an inorganic metal compound. The layer comprising the inorganic metal compound is usually formed by contacting to the above side of the aforementioned resin layer.

### [Macromolecular film]

With regard to a macromolecular film, a polymer material which is able to form a film having an excellent transparency may be used. As to the polymer material as such, any of thermoplastic polymer and hardening polymer may be used. Examples of the thermoplastic polymer are polyesters such as polyethylene terephthalate and polyethylene 2,6-naphthalate; polyolefins, polycarbonates; polyether sulfones; and polyallylates. Two or more thereof may be used jointly.

Among the above-mentioned thermoplastic polymers, polycaronates which are excellent in various respects such as heat resistance, mechanical characteristics and transparency are preferred. Here, a polycarbonate is a polyester of carbonic acid with glycol or dihydric phenol and an aromatic polycarbonate having a bisphenol component is advantageous.

Examples of the bisphenol component as such are 2,2-bis(4-hydroxyphenyl)propane (bisphenol A), 1,1-bis(4-hydroxyphenyl)cyclohexane (bisphenol Z), 1,1-bis(4-hydroxyphenyl-3,3,5-trimethylcyclohexane, 9,9-bis(4-hydroxyphenyl)fluorene and 9,9-bis(3-methyl-4-hydroxyphenyl)fluorene. Two or more of such a bisphenol component may be used jointly. Thus, the polycarbonate in the present invention may be a mixture of two or more substances or a copolymer having two or more bisphenol components.

The above-mentioned polymer is preferred to have a high glass transition temperature which is an index for heat resistance. For example, a homopolymer of a polycarbonate of a bisphenol A type (where bisphenol A is a bisphenol component) has a glass transition temperature of 150°C. Further, aromatic polycarbonates where 9,9-bis(4-hydroxyphenyl)fluorene or 9,9-bis(3-methyl-4-hydroxyphenyl)fluorene is copolymerized, for example, with bisphenol A have a glass transition temperature of around 200°C although that may depend upon the composition of the copolymer. In the case of aromatic polycarbonate copolymer as such, its copolymerizing composition is preferred to be that bisphenol A is 20 to 70 molar % when molding property, transparency, economy, etc. are taken into consideration. Macromolecular film having such a high resistance to heat is stable to thermal history during the manufacturing steps for the production of liquid crystal display elements, organic light emitting diode elements, electronic paper, etc. and, therefore, it is suitable for such a use.

On the other hand, polyester such as polyethylene terephthalate and polyethylene 2,6-naphthalate has a high rigidity when made into a film. In addition, it is of a high multiplicity of use and is advantageous in view of cost. When film of such a polyester is subjected to a biaxial elongation such as a successive biaxial elongation or a simultaneous biaxial elongation and then thermally fixed, its resistance to heat is able to be enhanced to an extent of about 150°C. Practical temperature of common biaxially elongated polyethylene terephthalate film is about 150°C while that of a biaxially elongated polyethylene 2,6-naphthalate is about 180°C.

With regard to such a macromolecular material, it is also possible to use a polymer in which several polymers are blended for achieving novel function in addition to transparency and rigidity.

As to the thickness of the macromolecular film, that of 0.01 to 0.4 mm may be usually used. For example, when used for electronic paper, the thickness is preferred to be about 0.1 to 0.2 mm in view of recognition by naked eye.

The macromolecular film may be in one film or two or more films may be layered. When two or more are layered, they may be adhered using an adhesive or may be made into multilayered product by means of a co-extrusion.

With regard to the macromolecular film in the present invention, either that having an excellent optical isotropy or that having an excellent anisotropy may be appropriately selected and used depending upon the use. When the layered film of the present invention is used for a device using a polarized plate for example, the macromolecular film is preferred to be that which has an excellent optical isotropy. In that case, retardation of the macromolecular film is preferably not more than 30 nm or, more preferably, not more than 15 nm.

### [Resin layer containing acrylate resin having a lactone ring]

In the transparent gas-barrier layered film of the present invention, a resin layer containing an acrylate resin having a lactone ring is produced on at least one side of the above-mentioned macromolecular film.

The acrylate resin having a lactone ring producing a resin layer is constituted from a repeating unit (A) having a lactone ring represented by the following formula (1) 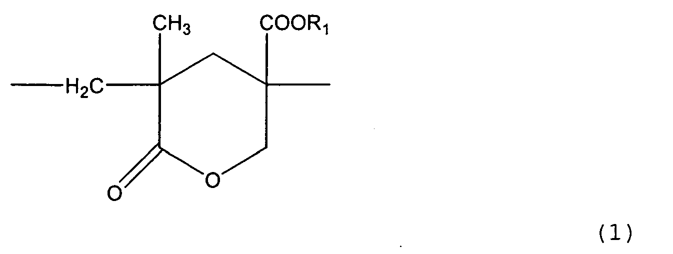 and another repeating unit (B) having no lactone ring represented by the following formula (2).

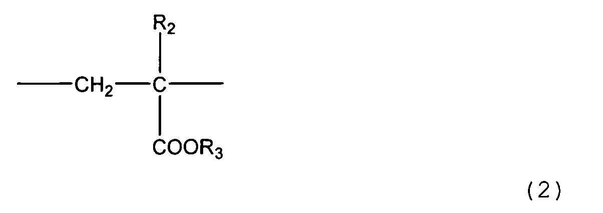

In the above formula (1), R₁ is an alkyl group having 1 to 8 carbon(s) and, for example, it is an alkyl group having 1 to 3 carbon(s) such as methyl group and ethyl group is preferred.

In the above formula (2), R₂ is hydrogen or methyl group. R₃ is at least one group selected from the group consisting of an alkyl group having 1 to 7 carbon(s) such as methyl group or ethyl group, cyclohexyl group and hydroxy ethyl group.

With regard to an acrylate resin having a lactone ring inducing the repeating unit (A) represented by the above formula (1), its specific example is an alkyl 2-(hydroxymethyl)-acrylate. Examples of the specific compound are methyl 2-(hydroxymethyl)acrylate, ethyl 2-(hydroxymethyl)acrylate, isopropyl 2-(hydroxymethyl)acrylate, n-butyl 2-(hydroxymethyl)acrylate, tert-butyl 2-(hydroxymethyl)-acrylate and 2-ethylhexyl 2-(hydroxymethyl)acrylate. Among them, particularly preferred ones are methyl 2-(hydroxymethyl)acrylate and ethyl 2- (hydroxymethyl) -acrylate. Each of them may be used solely or two or more thereof may be used jointly.

With regard to an acrylate resin having no lactone ring inducing the repeating unit (B) represented by the above formula (2), its specific examples are acrylate monomers such as methacrylic acid, acrylic acid and alkyl esters thereof., Examples of the specific compounds are an acrylate such as methyl acrylate, ethyl acrylate, n-butyl acrylate, isobutyl acrylate, tert-butyl acrylate, cyclohexyl acrylate, 2-hydroxyethyl acrylate and benzyl acrylate and a methacrylate such as methyl methacrylate, ethyl methacrylate, propyl methacrylate, n-butyl methacrylate, isobutyl methacrylate, tert-butyl methacrylate, cyclohexyl methacrylate, 2-hydroxyethyl methacrylate and benzyl methacrylate. Each of them may be used solely or two or more thereof may be used jointly. Among them, methyl methacrylate and methyl acrylate are preferred in view of resistance to heat and transparency. More preferred one is methyl methacrylate.

The, acrylate resin having a lactone ring includes a copolymerized polymer comprising the above-mentioned repeating unit (A) and the above-mentioned repeating unit (B), a mixture of a homopolymer comprising the repeating unit (A) with a homopolymer comprising the repeating unit (B) and a mixture thereof.

The acrylate resin containing a lactone ring is preferred to contain 3 to 50 molar % of the repeating unit (A) having a lactone ring to the total amount of the above-mentioned repeating unit (A) and the above-mentioned repeating unit (B). Thus, when a/(a + b) is 3 to 50 molar % in case the acrylate resin is constituted by containing a mol of the repeating unit A and b mol of the repeating unit B, a gas-barrier property of the layered film of the present invention is good. If a/(a + b) is 15 to 30 molar %, it is more advantageous as an undercoating layer for improving the barrier property by formation of a layer comprising an inorganic metal compound which will be mentioned later on the resin layer comprising the acrylate resin. When a/(a + b) is more than 50 molar %, solubility in a solvent becomes significantly bad and dissolving in a solvent when a resin layer comprising the acrylate resin becomes difficult. When it is less than 3 molar %, frequency where the lactone ring is present on the surface lowers and the barrier property tends to become bad.

It is preferred that number-average molecular weight of the above-mentioned acrylate resin having a lactone ring is within a range of about 10,000 to 1,000,000. More preferably, it is 10,000 to 300,000. When the number-average molecular weight is more than 1,000,000, a dissolving operation into a solvent necessary for the formation of a resin layer is substantially impossible. When the number-average molecular weight is less than 10,000, the outcome is not preferred because not only the function as a polymer is lost but also the self-supporting property as a resin layer is deteriorated. Incidentally, number-average molecular weight used here is able to be calculated as polystyrene by a gel permeation chromatography equipped with an ultraviolet visible detector "SPD-10A" manufactured by Shimadzu Corporation using tetrahydrofuran or chloroform as a mobile phase.

The above-mentioned resin layer contains an acrylate resin having a lactone ring and the amount of the acrylate resin is preferably not less than 5% by weight or, more preferably, 10 to 100% by weight or more.

Thickness of the above-mentioned resin layer is preferably within a range of 0.1 to 10 µm. More preferably, it is 1 to 5 µm.

The above-mentioned resin layer is preferred if an energy ray hardening resin is contained because a gas-barrier property is enhanced and close adhesion to the inorganic metal compound becomes good.

Such an energy ray hardening resin is a resin which is able to be hardened by at least one ray selected from the group consisting of heat ray, visible ray, ultraviolet ray, y ray and electronic ray. Such a resin may be used solely or plural resins may be used by mixing them. Examples of the resin which is able to be hardened by ultraviolet ray or electronic ray are tri- and higher multifunctional ultraviolet hardening acrylate resins. Examples of the resin which is able to be hardened by heat ray are epoxy resin and silicon-containing resin such as organopolysiloxan resin. In a broader sense, melamine resin, urethane resin, alkoxide resin, etc. are also included therein.

It is preferred in view of surface property and productivity to use an energy ray hardening resin in an amount of not less than 40% by weight on the basis of the total amount of the above-mentioned acrylate resin having a lactone ring and the energy ray hardening resin. The amount is preferably 60 to 90% by weight. It is preferred in view of a gas-barrier property that the above-mentioned acrylate resin is used in an amount of not more than 60% by weight on the basis of the above-mentioned total amount. More preferably, the acrylate resin is 10 to 40% by weight of the total amount.

Inorganic superfine particles may also be added to the above-mentioned resin layer with an object of improvement of a close adhering property. Examples of the inorganic superfine particles to be added are one or more kind(s) of inorganic superfine particles selected from the group consisting of silicon oxide, aluminum oxide, titanium oxide, zinc oxide, germanium oxide, magnesium fluoride and cerium oxide. Two or more thereof may be used jointly.

With regard to the particle size of the above-mentioned inorganic superfine particles, the particles where primary particle size is not more than 100 nm may be used. The reason is that, when the primary particle size is more than 100 nm, unevenness of the inorganic superfine particles affects on the surface of the resin layer to give an anti-glare effect or anti-Newton's ring effect but an increase in unevenness of the surface may inhibit the improvement in a gas-barrier effect. When the primary particle size of the inorganic superfine particles is smaller, that contributes in reduction of uneven surface and improvement in gas-barrier property which are objects of the present invention. However, as the size of the fine particles becomes smaller, the inorganic superfine particles are hardly dispersed. Accordingly, the lower limit of the primary particle size of the inorganic superfine particles will be about 5 nm. However, as the progress in the technique for dispersing, it may be possible that the primary particle size may be made further smaller.

It is preferred that the inorganic superfine particles are contained in an amount of not more than 30 phr in terms of solid weight rate to the resin layer. When it is more than 30 phr, haze of the resin layer becomes high and that is not preferred.

In the present invention, the resin layer may be formed at least on one side of the macromolecular film although it is of course possible to form on both sides.

In addition, although the resin layer may be formed directly by contacting onto the macromolecular film, it is also possible to be formed via an intermediate layer such as adhesive layer, UV cutting layer or refractive index adjusting layer.

The resin layer of the present invention containing acrylate resin having a lactone ring may be formed by known coating methods. Particularly preferred ones are a bar coat method using a Meyer's bar, a gravure coat method using a rotary microgravure method and a die coat method using a slit die and a gravure method having high controlling property and productivity is particularly suitable.

The resin layer is able to be manufactured by the above method and, to be more specific, as follows. Thus, an example of the method is that the above-mentioned acrylate resin is dissolved in a solvent in which the resin is soluble, the resin solution is then applied onto the surface of the macromolecular film by a common method to form a liquid membrane and the solvent is evaporated from the liquid membrane by, for example, heating and drying.

### [Layer comprising an inorganic metal compound]

The layer comprising an inorganic metal compound in the present invention is the so-called barrier membrane having a function of suppressing the permeation of water, oxygen, etc. Here, the inorganic metal compound contains at least one element selected from the group consisting of silicon, aluminum, magnesium, titanium, tantalum, indium, tin and zinc and the inorganic metal compound is an oxide, a nitride or an acid nitride of the above-mentioned metal. Two or more kind(s) thereof may be mixed and used.

Specific examples of the above-mentioned inorganic metal compound are silicon oxide, silicon nitride, silicon acid nitride, aluminum oxide, aluminum nitride and aluminum acid nitride. They are good in terms of economy, molding property and transparency.

Among the above, silicon oxide represented by a chemical formula SiOₓ is much preferred because it is able to form a more transparent layer. The value x of the SiOₓ membrane is preferably 1.0 to 1.9, more preferably 1.5 to 1.9 and, still more preferably, 1.7 to 1.9. With regard to a method for deciding of x for the SiOₓ membrane, known methods such as an Auger electronic analysis method, X-ray photoelectronic analysis method or Rutherford backscattering spectroscopy may be used.

The above-mentioned inorganic metal compound may be made into a layer by the following formation method. It is, for example, a DC magnetron sputtering method, an RF magnetron sputtering method, an ion plating method, a vacuum deposition method, a pulse laser deposition method and a physical formation method where the above-mentioned ones are compounded. When attention is paid to an industrial productivity that a layer of uniform thickness is formed within a big area, a DC magnetron sputtering method (hereinafter, it will be referred to as a sputtering) is preferred. Incidentally, in addition to the above-mentioned physical formation methods, it is also possible to use a chemical formation method such as a chemical vapor deposition (hereinafter, referred to as CVD) and a sol-gel method.

In a sputtering method, a metal target is used as a target and a reactive sputtering method may be used. The reason is that there are many cases where oxide, nitride or acid nitride of element used as a barrier membrane is an insulating material whereby a DC magnetron sputtering method is not applicable. Recently, a source in which two cathodes are discharged at the same time to suppress the formation of insulating materials has been developed and a pseudo RF magnetron sputtering method may be applied to the present invention as well.

When a layer comprising the above-mentioned inorganic metal compound is formed by a DC magnetron sputtering method using a metal target in the present invention, it is possible to form the layer by such a method where pressure (back pressure) in the vacuum tank upon formation of said layer is once made not more than 1.3 × 10⁻⁴ Pa and the inert gas and oxygen are introduced. It is preferred to once make the pressure in the vacuum tank not more than 1.3 × 10⁻⁴ Pa for reducing the influence of molecular species which may reside in the vacuum tank and affect the barrier characteristic of the thin membrane of the inorganic chemical compound. More preferably, it is not more than 5 × 10⁻⁵ Pa and, still more preferably, it is not more than 2 × 10⁻⁵ Pa.

After that, inert gas is introduced. With regard to the inert gas as such, He, Ne, Ar, Kr or Xe may be used for example and it has been said that, when the inert gas having higher atomic weight is used, damage to the resulting layer is less and flatness of the surface is enhanced. However, when cost is taken into consideration, Ar is desirable. In order to adjust the oxygen concentration to be taken into the layer, 1.3 × 10⁻³ to 7 × 10⁻² Pa of oxygen in terms partial pressure may be added to the inert gas. Besides oxygen, it is also possible to use O₃, N₂, N₂O, H₂O, NH₃, etc. depending upon the object.

In the present invention, it is further possible to form it by a manufacturing method where partial pressure of water in a vacuum tank where said layer is formed is made not more than 1.3 × 10⁻⁴ Pa and then inert gas and oxygen are introduced thereinto. More preferably, the partial pressure of water is able to be controlled in not more than 4 × 10⁻⁵ Pa and, still more preferably, not more than 2 × 10⁻⁵ Pa. However, in order to mitigate the stress in the layer by means of incorporation of hydrogen into the layer, water may be intentionally introduced thereinto within a range of 1.3 × 10⁻⁴ to 3 × 10⁻² Pa. Such an adjustment is able to be carried out by such a manner that, after a vacuum state is once formed, water is introduced using a variable leak valve or a mass flow controller. It is also possible to conduct by controlling the back pressure of the vacuum tank.

In deciding the partial pressure of water, an in-process monitor of a differential pumping type may be used as well. It is also possible to use a quadrupole mass spectrometer having a wide dynamic range and being able to measure even under a pressure of about 0.1 Pa. Usually, under a degree of vacuum of about 1.3 × 10⁻⁵ Pa, that which forms such a pressure is water. Accordingly, the value measured by a vacuum gage may be directly adopted as a partial pressure of water.

Since a macromolecular film is used in the present invention, it is necessary to adjust the temperature to an extent of from about below room temperature to a softening point of the macromolecular film for the formation of a layer comprising the inorganic metal compound. In the case of polyethylene terephthalate film which is the representative macromolecular film, it is desirable that said layer is formed where the film is kept at the temperature of not higher than 80°C when no special treatment is carried out. More desirably, the substrate temperature is not higher than 50°C and, still more desirably, not higher than 20°C. Even in the case of a heat resistant macromolecular film, it is recommended to form at the temperature set at not higher than 80°C, more preferably at not higher than 50°C and, still more preferably, at not higher than 20°C in view of the control of the out-gas from the macromolecular film.

When the layer comprising the inorganic metal compound in the present invention is formed by the above-mentioned method directly on the above-mentioned resin layer containing an acrylate resin having a lactone ring, it is now easy to achieve adhesive property, gas-barrier property and prevention of generation of interference fringe whereby that is preferred.

The transparent gas-barrier layered film of the present invention prepared as such has a good transparency. Transmittance of whole light through the transparent gas-barrier layered product is preferably not less than 80% and, more preferably, not less than 85%.

In addition, the transparent gas-barrier layered film of the present invention has a good gas-barrier property to vapor and oxygen. Method for the measurement of the barrier will be mentioned later and degree of permeation of vapor of the transparent gas-barrier layered film of the present invention is preferably not more than 1 g/m²/day, more preferably not more than 0.5 g/m²/day and, still more preferably, not more than 0.1 g/m²/day.

Degree of permeation of oxygen is preferably not more than 5 cc/m²/day, more preferably not more than 2 cc/m²/day and, still more preferably, not more than 1 cc/m²/day.

As such, the transparent gas-barrier layered film of the present invention has high transparency and has excellent barrier property against vapor and oxygen. Therefore, it is able to be advantageously used as a substrate of, for example, liquid crystal display element, touch panel, organic light emitting diode element, electronic paper, filmy solar battery (both dry and wet types) and electronic tag.

More preferred embodiment of the present invention is as follows.

Thus, it is a transparent gas-barrier layered film having a resin layer comprising an energy ray hardening resin and an acrylate resin having a lactone ring and a layer comprising an inorganic metal compound successively on at least one side of a macromolecular film in which said acrylate resin is constituted by containing a repeating unit (A) having a lactone ring represented by the following formula (1) 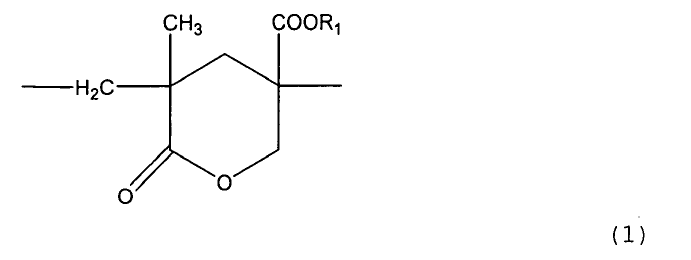 and a repeating unit (B) having no lactone ring represented by the following formula (2) 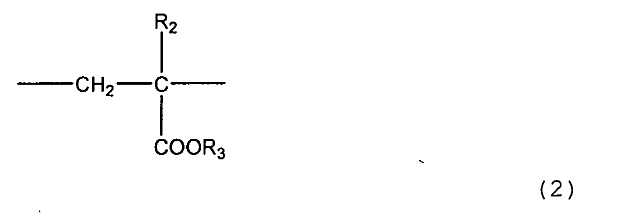 where, when the amount of the repeating unit (A) is a mol and the amount of the repeating unit (B) is b mol, then a/(a + b) is within a range of 3 to 50 molar % and, in the above-mentioned resin layer, the ratio of the acrylate resin to the total amount of the acrylate resin and the energy ray hardening resin is within a range of not more than 60% by weight.

### [Transparent electrically conductive layer]

When the transparent gas-barrier layered film of the present invention further has a transparent electrically conductive layer, it is able to be used as, for example, electrode material, shielding material for electromagnetic wave and ultraviolet cutting material. Here, the transparent electrically conductive layer is a layer constituted from a metal oxide. Examples of the metal oxide as such are oxides comprising indium oxide containing tin, tellurium, cadmium, molybdenum, tungsten, fluorine or zinc, tin oxide containing antimony, tin oxide and cadmium oxide. Among them, indium oxide containing 1 to 30% by weight of tin (ITO) and indium oxide containing 1 to 30% by weight of zinc (IZO) are preferred in view of transparency and electric conductivity. It is also possible to add, for example, silicon, titanium or zinc as the third element to the ITO or IZO.

In order to achieve a sufficient electric conductivity, thickness of such a transparent electrically conductive layer is preferably not less than 5 nm and, in order to achieve a layer having a sufficiently high transparency, the thickness is preferably not more than 300 nm. More preferably, it is 10 to 250 nm.

The above-mentioned transparent electrically conductive layer may be directly formed on the above-mentioned layer comprising the inorganic metal compound or may be formed via an adhesive layer, an ultraviolet cutting layer or a refractive index adjusting layer.

A preferred example of the preferred constitution of the layered film of the present invention is that a resin layer containing an acrylate resin having a lactone ring, a layer comprising an inorganic metal compound and a transparent electrically conductive layer are formed on one side of the macromolecular film in this order.

With regard to a method for formation of the above-mentioned transparent electrically conductive layer, a common method may be used. Examples thereof are known vacuum method for the manufacture of membrane such as sputtering method, ion plating method, vacuum deposition method and CVD method. Among them, a sputtering method is particularly preferred in view of uniformity of layer thickness in the directions of width and length and uniformity of the composition.

### Examples

The present invention will now be illustrated in detail by way of the following Examples. However, the present invention is not limited to those Examples at all.

### (Method for evaluation)

### (1) Barrier property against vapor and oxygen

Barrier property of a transparent gas-barrier layer film against vapor was measured using "Permatran" (trade name) manufactured by Modern Control. Barrier property against oxygen was measured using "Oxytran" (trade name) manufactured by Modern Control.

### (2) Transmission rate of the whole light

Transmission rate of the whole light was measured using "NDH 2000" (trade name) manufactured by Nippon Denshoku Kogyo. Transmission of the whole light is in accordance with JIS K 7361.

### (3) Close adherence

Close adherence was measured using a cross cut method. On the surface of the layered film, 100 squares each being 1 mm × 1 mm were formed on the surface of a layered film using a cutter and a cellophane tape (manufactured by Nichiban) was adhered thereon. Evaluation was conducted by counting the numbers of the squares where a part of the layered film remained on the layered film when the cellophane tape was removed. Thus, definition was that 100/100 was the best while 0/100 means that all were removed.

### (4) Preparation of acrylate resin having a lactone ring and its solution

Acrylate resins having a lactone ring were two kinds of the resins manufactured by Nippon Shokubai represented by the following formulae 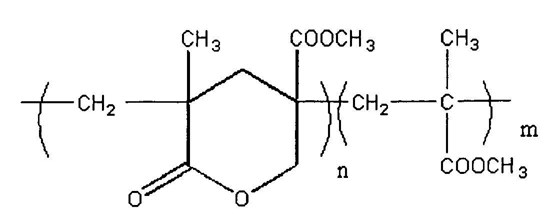 where copolymerizing ratio was different.
Resin A1 where n:m = 20:80 (molar ratio)
Resin A2 where n:m = 25:75 (molar ratio)
Each of those two kinds of acrylate resins was dissolved in a 1:1 mixture (by ratio) of hot toluene and hot MIBK (methyl isobutyl ketone) to make the concentration 20% by weight to prepare a resin solution.

### (5) Resin of energy-hardening type

With regard to resin of an energy-hardening type, a solution where "NK Oligo U15HA-50P" (trade name) which is a 15-functional acrylate oligomer being an ultraviolet-hardening type resin manufactured by Shin Nakamura Kogyo was dissolved in 1M2P (1-methoxy-2-propanol) in 50% by weight and a solution of "NK Oligo U6HA-50P" (trade name) which is a 6-functional acrylate oligomer was dissolved in 1M2P in 50% by weight were used as the resin B1 and B2, respectively.

To B1 and B2 each was added 1-hydroxycyclohexyl phenyl ketone ("Irgacure 184" (trade name) manufactured by Ciba Speciality Chemicals) as an initiator in 5% by weight of B1 and B2 each.

### [Example 1]

As a macromolecular film, "Tetron" (OPFW, thickness: 125 µm) which was a biaxially elongated polyethylene terephthalate film manufactured by Teijin-Du Pont Film was used. On one side of this film, a dope for formation of a resin layer was prepared in such a manner that the resin solution prepared in the above (4) was used and diluted with 1M2P so that the partial rate by weight of the resin A1 to the resin B1 and solid concentration were finally made 25:75 and 22.5% by weight, respectively.

Then this dope was applied on one side of the polyethylene terephthalate film using a Meyer bar and dried at 70°C for 1 minute. Then UV light of 250 nm was irradiated onto the applied surface for 1 minute. After that, it was allowed to stand in a drier of 130°C for 3 minutes to give a resin layer of 2.5 µm thickness.

Then, the polyethylene terephthalate film where a resin layer was formed was poured into a sputtering chamber. The ultimate degree of vacuum in the chamber was made not more than 1.3 E-5 Pa and oxygen was introduced to an extent of 2.6 E-2 Pa. Further, 2.6 E-3 Pa of water was introduced into the chamber and then Ar was introduced thereinto as a process gas so as to make the total pressure 0.4 Pa. Electric power was introduced to an Si target with electric density of 2 W/cm² and 30 nm of SiOₓ layer was formed on the resin layer by a reactive DC magnetron sputtering method to manufacture a transparent gas-barrier layered film.

Vapor permeating amount of this transparent gas-barrier layered film was 0.09 g/m²/day and oxygen permeating amount thereof was 1.0 cc/m²/day. Transmission rate of the whole light was 90% and x of SiOₓ was determined to be 1.9 by an Auger electron spectroscopic method. Result of the cross-cut was 100/100. This layered film was subjected to a heating treatment at 130°C for 2 hours but there was no change in the above-mentioned characteristics.

### [Example 2]

The same operation as in Example 1 was carried out except that "Teonex" (Q65A, thickness: 200 µm) which was a biaxially elongated polyethylene 2,6-naphthalate film manufactured by Teijin-Du Pont Film as a macromolecular film to manufacture a transparent gas-barrier layered film.

Vapor permeating amount of this transparent gas-barrier layered film was 0.08 g/m²/day and oxygen permeating amount thereof was 0.9 cc/m²/day. Transmission rate of the whole light was 90% and x of SiOₓ was determined to be 1.9 by an Auger electron spectroscopic method. Result of the cross-cut was 100/100. This layered film was subjected to a heating treatment at 130°C for 2 hours but there was no change in the above-mentioned characteristics.

### [Example 3]

The same operation as in Example 1 was carried out except that a polycarbonate manufactured by Teijin Kasei ("Pure Ace" WR, thickness: 120 µm) was used as a macromolecular film to manufacture a transparent gas-barrier layered film.

Vapor permeating amount of this transparent gas-barrier layered film was 0.10 g/m²/day and oxygen permeating amount thereof was 1.2 cc/m²/day. Transmission rate of the whole light was 90% and x of SiOₓ was determined to be 1.9 by an Auger electron spectroscopic method. Result of the cross-cut was 100/100. This layered film was subjected to a heating treatment at 130°C for 2 hours but there was no change in the above-mentioned characteristics.

### [Example 4]

The same operation as in Example 1 was carried out except that a combination of the resin A2 with the resin B2 was used instead of a combination of the resin A1 with the resin B1 to manufacture a transparent gas-barrier layered film.

Vapor permeating amount of this transparent gas-barrier layered film was 0.15 g/m²/day and oxygen permeating amount thereof was 1.5 cc/m²/day. Transmission rate of the whole light was 90% and x of SiOₓ was determined to be 1.9 by an Auger electron spectroscopic method. Result of the cross-cut was 100/100. This layered film was subjected to a heating treatment at 130°C for 2 hours but there was no change in the above-mentioned characteristics.

### [Example 5]

The same operation as in Example 1 was carried out except that a combination of the resin A1 with the resin B2 was used instead of a combination of the resin A1 with the resin B1 to manufacture a transparent gas-barrier layered film.

Vapor permeating amount of this transparent gas-barrier layered film was 0.10 g/m²/day and oxygen permeating amount thereof was 1.1 cc/m²/day. Transmission rate of the whole light was 90% and x of SiOₓ was determined to be 1.9 by an Auger electron spectroscopic method. Result of the cross-cut was 100/100. This layered film was subjected to a heating treatment at 130°C for 2 hours but there was no change in the above-mentioned characteristics.

### [Example 6]

The same operation as in Example 1 was carried out except that only the resin A1 was used instead of a combination of the resin A1 with the resin B1 to manufacture a transparent gas-barrier layered film.

Vapor permeating amount of this transparent gas-barrier layered film was 0.10 g/m²/day and oxygen permeating amount thereof was 1.1 cc/m²/day. Transmission rate of the whole light was 90% and x of SiOₓ was determined to be 1.9 by an Auger electron spectroscopic method. Result of the cross-cut was 100/100. This layered film was subjected to a heating treatment at 130°C for 2 hours whereupon wrinkles were resulted in the resin layer and were observed as interference fringe whereupon the product was not sufficient for use as a display.

### [Comparative Example 1]

The same operation as in Example 1 was carried out except that only the resin B1 was used instead of a combination of the resin A1 with the resin B1 to manufacture a layered film.

Vapor permeating amount of this layered film was 1.50 g/m²/day and oxygen permeating amount thereof was as high as 3.6 cc/m²/day. Transmission rate of the whole light was 90% and x of SiOₓ was determined to be 1.9 by an Auger electron spectroscopic method. Result of the cross-cut was 100/100. This layered film was subjected to a heating treatment at 130°C for 2 hours whereupon warp of the film was significantly big due to shrinking of the resins layer whereupon the product resulted in a problem in practical use.

### [Example 7]

On the SiOₓ layer of the transparent gas-barrier layered film prepared in Example 1, a transparent electrically conductive layer was formed by a DC magnetron sputtering method according to the following method.

Back pressure of the vacuum tank was made 1.3 E-5 Pa, oxygen gas was introduced thereinto as a reaction gas and then Ar was further introduced thereinto as an inert gas so that the total pressure in the vacuum tank was made 0.4 Pa. At that time, partial pressure of water before introduction of the inert gas as measured by a quadrupole mass spectrometer was the same as the back pressure of the vacuum tank read by an ionization gauge. Partial pressure of oxygen was 2.7 E-3 Pa.

As to a sintered target, a target comprising In-Zn-O containing 7.5% by weight of zinc oxide was used. Sputtering was conducted with electric power density of 2 W/cm² and temperature of the layered film was made 20°C to form a transparent electrically conductive layer having a thickness of 15 nm was prepared.

Surface resistance of the transparent electrically conductive layer was 300 Ω/□. Transmission rate of the whole light through the whole layered film was 87%. Result of cross-cut of the transparent electrically conductive layer was 100/100. Vapor permeating amount was not more than 0.1 g/m²/day and oxygen permeating amount was not more than 0.1 cc/m²/day. When this layered film was subjected to a heating treatment at 130°C for 2 hours, its surface resistance became 320 Ω/□ and transmission rate of whole light was 88%. There was no change in the close adhering property.

### [Example 8]

A transparent electrically conductive layer was prepared by the same method as in Example 7 except that a target comprising In-Sn-O containing 10% by weight of tin oxide was used as a sintering target on an SiOₓ layer of the transparent gas-barrier layered film prepared in Example 1.

Surface resistance of the transparent electrically conductive layer was 300 Ω/□. Transmission rate of the whole light through the whole layered film was 87%. Result of cross-cut of the transparent electrically conductive layer was 100/100. Vapor permeating amount was not more than 0.1 g/m²/day and oxygen permeating amount was not more than 0.1 cc/m²/day. When this layered film was subjected to a heating treatment at 130°C for 2 hours, its surface resistance became 280 Ω/□ and transmission rate of whole light was 88%. There was no change in the close adhering property.

### Industrial Applicability

The transparent gas-barrier layered film of the present invention has a high transparency and shows an excellent gas-barrier property against vapor and oxygen. Therefore, it is able to be advantageously used as a substrate for electronic paper, liquid crystal display device, touch panel, organic light emitting diode element, filmy solar battery and electronic tag.

## Claims

1. A transparent gas-barrier layered film having a resin layer containing acrylate resin having a lactone ring and a layer comprising an inorganic metal compound at least on one side of a macromolecular film.

2. The layered film according to claim 1, wherein the acrylate resin is constituted by containing a repeating unit (A) having a lactone ring represented by the following formula (1) 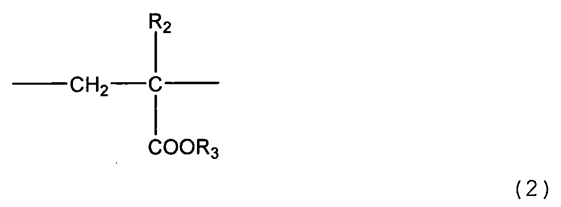 and a repeating unit (B) having no lactone ring represented by the following formula (2).

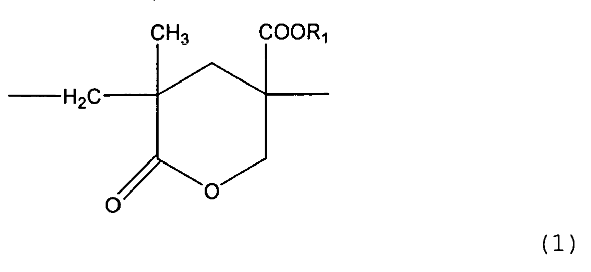

3. The layered film according to claim 2, wherein, when the amount of the repeating unit (A) is a mol and the amount of the repeating unit (B) is b mol, then a/(a + b) is within a range of 3 to 50 molar %.

4. The layered film according to claim 1, wherein the resin layer comprises the acrylate resin and an energy ray hardening resin and the ratio of the acrylate resin to the total amount of the acrylate resin and the energy ray hardening resin is within a range of not more than 60% by weight.

5. The layered film according to claim 1, wherein the inorganic metal compound is oxide, nitride or acid nitride containing at lest one element selected from the group consisting of silicon, aluminum, magnesium, titanium, tantalum, indium, tin and zinc.

6. The layered film according to claim 5, wherein the inorganic metal compound is SiOₓ and the value of x is from 1.0 to 1.9.

7. The layered film according to claim 1, wherein a vapor permeating rate is not more than 1 g/m²/day.

8. The layered film according to claim 1, wherein an oxygen permeating rate is not more than 5 cc/m²/day.

9. The layered film according to claim 1, wherein the film further has a transparent electrically conductive layer.

10. The layered film according to claim 9, wherein the transparent electrically conductive layer comprises at least one oxide of an element selected from the group consisting of indium, tin, zinc, gallium and aluminum.

11. The layered film according to claim 9, wherein a resin layer containing an acrylate resin having a lactone ring, a layer comprising an inorganic metal compound and a transparent electrically conductive layer are formed in this order on one side of the macromolecular film.

12. A transparent gas-barrier layered film having a resin layer comprising an energy ray hardening resin and an acrylate resin having a lactone ring and a layer comprising an inorganic metal compound successively on at least one side of a macromolecular film in which said acrylate resin is constituted by containing a repeating unit (A) having a lactone ring represented by the following formula (1) 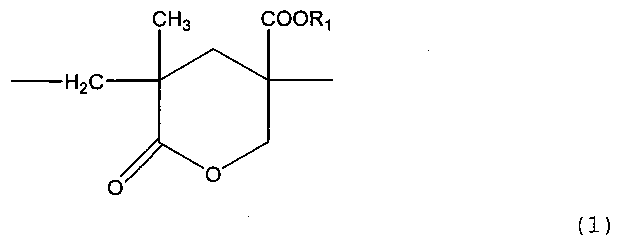 and a repeating unit (B) having no lactone ring represented by the following formula (2) 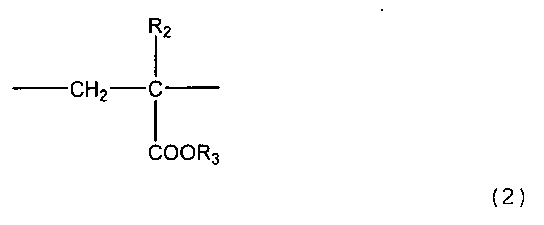 where, when the amount of the repeating unit (A) is a mol and the amount of the repeating unit (B) is b mol, then a/(a + b) is within a range of 3 to 50 molar % and, in the resin layer, the ratio of the acrylate resin to the total amount of the acrylate resin and the energy ray hardening resin is within a range of not more than 60% by weight.
